Europäisches Patentamt

European Patent Office

Office européen des brevets

(11) Publication number: **0 215 515**
**B1**

(12) **EUROPEAN PATENT SPECIFICATION**

(45) Date of publication of patent specification: **17.01.90**

(21) Application number: **86201500.5**

(22) Date of filing: **01.09.86**

(51) Int. Cl.⁵: **G 01 R 13/32, G 01 R 13/06**

(54) **Wave form analyser, especially transient recorder.**

(30) Priority: **04.09.85 NL 8502433**

(43) Date of publication of application:
**25.03.87 Bulletin 87/13**

(45) Publication of the grant of the patent:
**17.01.90 Bulletin 90/03**

(84) Designated Contracting States:
**AT BE CH DE FR GB IT LI LU NL SE**

(56) References cited:
**DE-A-2 739 230**
**US-A-4 100 532**
**US-A-4 399 512**

**ELEKTROTECHNIK, vol. 62, no. 14, 21st July
1980, pages 10-13, Würzburg, DE; S.
SCHLEINKOFER: "Registriert und speichert
schnelle Vorgänge"**

(73) Proprietor: **Bakker Electronics Dongen B.V.
Minister Aalberselaan 10
NL-5103 BA Dongen (NL)**

(72) Inventor: **Bakker, Johannes Hermanus
Beneluxlaan 20
NL-5101 ZD Dongen (NL)**

(74) Representative: **Konings, Lucien Marie Cornelis
Joseph et al
OCTROOIBUREAU ARNOLD & SIEDSMA
Sweelinckplein 1
NL-2517 GK Den Haag (NL)**

Courier Press, Leamington Spa, England.

## Description

The invention relates to a waveform-analyser, especially a transient recorder, in accordance with the preamble of Claim 1.

Such a transient recorder is known for example from the article by S. Schleinkofer: "Registriert und speichert schnelle Vorgänge" p. 10—13, Elektrotechnik, volume 62, no. 14, July 1980, and is used for example to detect when a signal originating from the mains voltage exceeds a particular value, as a reaction to which the signal is recorded in the recording module.

A disadvantage of such a transient recorder are the limited possibilities for setting triggering event.

It is an object of this invention to provide a transient recorder with more triggering capabilities.

Therefore, the waveform-analyser according to this invention is characterized according to Claim 1.

In the transient recorder according to the present invention two detection levels can be set and exceeding of one or various of these detection levels by the digitized signal in a particular sequence determines the moment in time when the digital storage of the digitized signals into the memory should be stopped.

As such two detection levels for analog signals of an analog transient recorder are known from DE—A—2739230.

Further advantages and features of the transient recorder according to the present invention will be described with reference to the drawings in which:

Fig. 1 shows an embodiment of a transient recorder according to the invention;

Fig. 2 is a block diagram of the transient recorder from Fig. 1;

Fig. 3 shows a block diagram of the detection member from Fig. 2; and

Fig. 4 is a block diagram of a preferred embodiment of the detection member from Fig. 2.

In an embodiment of a transient recorder 15 according to the invention a recording module 17 is now coupled via an input 16 and a lead 18 with transient signals. Each recording module 17 is connected in a manner not shown with control means 22, which are linked to a display screen 21 on which these transient signals and all control functions of the transient recorder 15 can be displayed. For easy operation transient recorder 15 is provided with a positioning member 23, a so-called mouse. For convenient use all components of transient recorder 15 are accommodated in a cabinet 24 which can for example be placed on a table 25 and which is provided on the front with read/write devices 20 which are arranged to read and/or write to information discs for the control program and for recording transient signals.

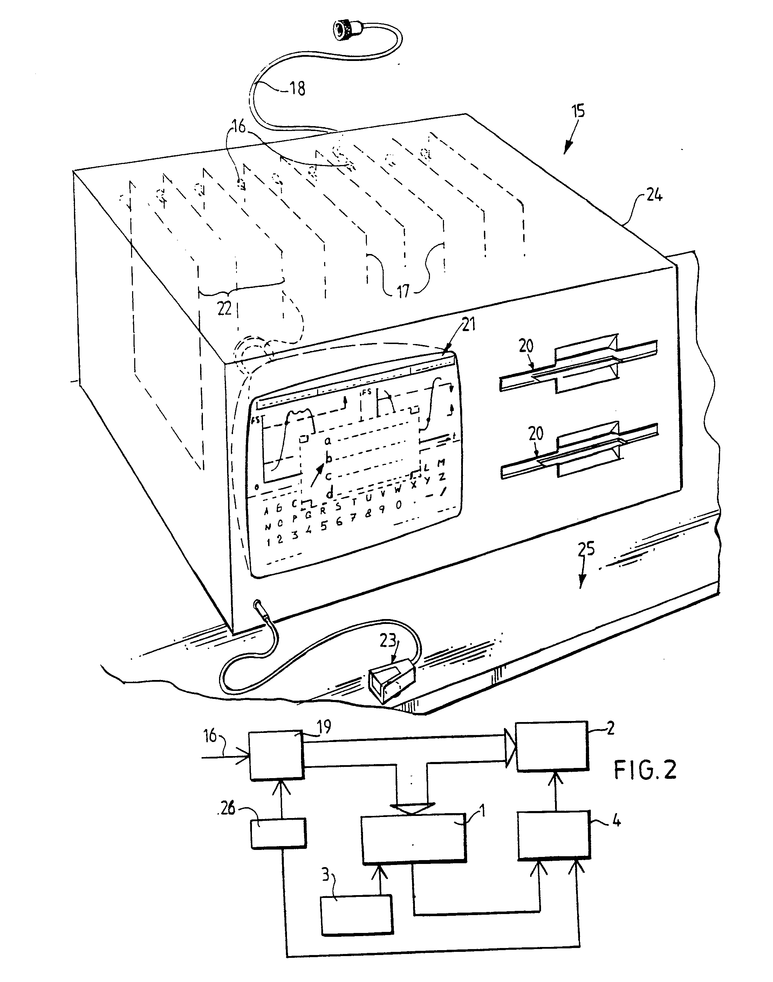

The input 16 is connected to an analog-digital converter 19 (Fig. 2) which converts the analog signal into a digital signal of for example sixteen bits and which is controlled by a clock member 26. The digital signals, the so-called samples, are fed continuously to a digital memory 2, whereby in each case the last sample arriving in the digital memory shifts into it and whereby the last recorded sample shifts out of the memory. Memory 2 is controlled by a memory control circuit 4 which is also controlled by clock member 26. Depending on a signal emanating from a detection member 1, a so-called trigger signal, which is likewise fed to the memory control circuit 4, the storing of samples in the memory can be stopped so that a transient signal is then stored in the memory 2. One or various detection levels can be set in the setting means 3, depending on which the detection member 1 does or does not generate a trigger signal.

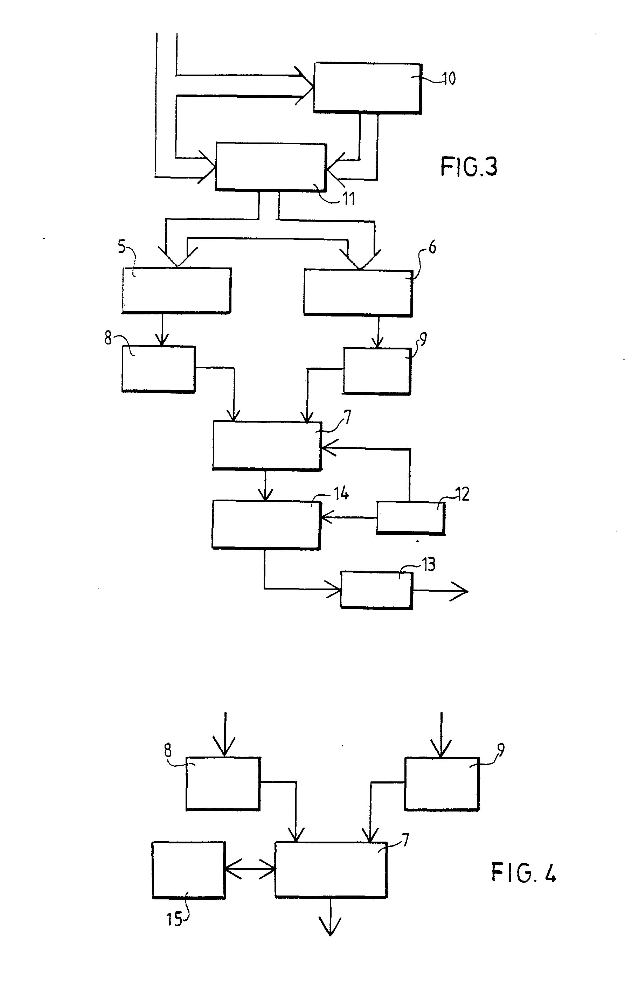

To be seen in more detail (Fig. 3) is that the digital signals or samples are fed in the first instance to an arithmetic unit 10 and an adjustable switch member 11, whereby switch member 11 either transmits via setting means 3 the difference signals or other arithmetic signals emanating from two samples to two comparing elements 5, 6, or transmits the digital signals directly to said elements, whereby a detection level is set by the setting means 3 in each comparing element 5, 6. Each comparing element 5, 6 is connected via peak filters 8 and 9 respectively to a logic element 7. The peak filter can be adjusted such that, when samples remain constant during the time period of a pre-set number of samples, peak filters 8 and 9 transmit the output signal of the comparing elements 5 and 6 respectively to the logic element 7. The peak filter can also be adjusted such that when samples remain constant for less than the time period of a pre-set number of samples, it transmits the output signal of the comparing element to the logic element. As a result either broad peaks or narrower peaks are detected using the detection member. The logic element 7 is function adjustable and is assembled from per se known electronic elements. Logic element 7 is linked to a counter that can be adjusted by the setting means 3 for supplying an output signal to a delaying element 13 which can likewise be adjusted by the setting means, which element in turn activates the memory control circuit 4. In addition a turn-off element 12 which can be adjusted by the setting means 3 is coupled between the counter 14 and the logic element 7 and can make the logic element inactive for a determined period of time.

Using detection member 1, control means 22 and setting means 3 it is possible to adjust the detection levels and the logic element 7 such that, in addition to the usual "level-triggering", depending on the signal level emanating from the transient phenomenon, there are detecting possibilities present:

"sequential triggering", the control circuit 4 is activated as soon as the signal level exceeds a first detection level in a pre-set direction after having first exceeded a second detection level in pre-set direction.

"window triggering" — much used in scintillation counters —, the control circuit 4 is activated as soon as the signal level not located between both detection levels exceeds only one of both detection levels successively in different directions, without the other detection level being exceeded in the meantime.

"alarm triggering", the control circuit 4 is activated as soon as one or both detection levels is exceeded in a pre-set direction.

Using the arithmetic unit 10 and the adjustable switch member 11 the above mentioned possibilities can also be effected for the difference between successive samples, the so-called differential mode. Using counter 14, and only after the logic element 7 has generated a signal thereto a number of times, a signal can be transmitted to the memory control circuit 4, which can be required for the recording of particular phenomena. Also a frequent requirement is to build in some measure of delay, so that recording is not stopped immediately after the occurrence of a transient phenomenon; this is effected with the adjustable delaying element 13. Immediate activation of the memory control circuit 4 can be prevented also using turn-off element 12.

A window circuit 15 can be connected to logic element 7 (Fig. 4). With this window circuit two points of time for example can be set in logic element 7. As a result, whether or not an output signal is generated by logic element 7 can depend on these points of time. After receiving a signal from the peak filter 8 logic element 7 can thus for example only generate a signal after it has received a signal from the peak filters 9 after a determined point in time. Logic element 7 can also for example only generate a signal if, after receiving a signal from a first peak filter, a signal is received from the other peak filter between the two points in time. It is for example even possible that the logic element 7 generates a signal if a signal is received from the second peak filter either before the first point of time or after the second point of time.

Use of the invention results in a detection member that has flexibility of adjustment and which can even be produced in integrated form, so that it occupies little space and can be easily built into a convenient transient recorder in each recording module.

Further details of the transient recorder according to the invention can be learned from the copending patent application based on NL 8502432 (corresponding to EP—A—0 216 414 published 01.04.87).

**Claims**

1. Waveform analyser, especially transient recorder (15) for digitally recording signals emanating from a transient phenomenon of a relatively short duration, comprising at least one recording module (17) comprising an input (16) which is to be connected to the transient signals, an analog-to-digital converter (19) connected to said input (16) and a detection member (1) connected to said converter (19) for detecting the point of time at which the digital storage of a signal in a memory (2) is to take place, which detection member (1) is provided with setting means (3) for setting detection levels characterized by two or more comparing elements (5, 6) for digitized signals, which are part of said detection member (1) and are fed with signals from the analog-digital converter (19) and adjustable through said setting means (3), for comparing the digitized signal level with two or more said digital detection levels and also being a part of said detection member (1), a functionally adjustable logic element (7) connected to the outputs of said comparing elements (5, 6), the output of the logic element being connected to a memory control circuit (4) which is connected to said memory (2) for controlling storage of said digitized signals into said memory (2) in accordance with the output signal of the detection member (1).

2. Waveform analyser, especially transient recorder, (15) as claimed in Claim 1, characterized in that the logic element (7) can be functionally adjusted such that the control circuit (4) is activated as soon as the signal level exceeds a first detection level in a pre-set direction after having first exceeded a second detection level in pre-set direction.

3. Waveform analyser, especially transient recorder, (15) as claimed in Claim 1 or 2, characterized in that the logic element (7) can be functionally adjusted and the setting means (3) can be adjusted such that the control circuit (4) is activated as soon as the signal level exceeds only one of both detection levels successively in different directions.

4. Waveform analyser, especially transient recorder, (15) as claimed in Claim 1, 2 or 3, characterized in that the logic element (7) can be functionally adjusted such that the control circuit (4) is activated as soon as the signal level exceeds one or both detection levels in a pre-set direction.

5. Waveform analyser, especially transient recorder, (15) as claimed in any of the foregoing claims, characterized in that a peak filter (8, 9) is connected between each comparing element (5, 6) and the logic element (7).

6. Waveform analyser, especially transient recorder, (15) as claimed in Claim 5, characterized in that the peak filter can be adjusted such that when samples remain constant during the time period of a pre-set number of samples, said peak filter transmits the output signal of the comparing element (5, 6) to the logic element (7).

7. Waveform analyser, especially transient recorder, (15) as claimed in Claim 5 or 6, characterized in that the peak filter can be adjusted such that when samples remain constant for less than the time period of a pre-set number of samples, said peak filter transmits the output signal of the comparing element (5, 6) to the logic element.

8. Waveform analyser, especially transient recorder, (15) as claimed in any of the foregoing claims, characterized by an arithmetic unit (10) for calculating the difference between two samples and by a switching member (11) adjustable by setting means (3) for switching either the signal level of said difference to the comparing elements (5, 6).

9. Waveform analyser, especially transient recorder, (15) as claimed in Claim 8, characterized in that the arithmetic unit (10) can be adjusted such that it arranges and stores the successive differences during a pre-set period of time.

10. Waveform analyser, especially transient recorder, (15) as claimed in any of the foregoing claims, characterized by a counter (14) adjustable by the setting means (3) and coupled between the logic element (7) and the memory control circuit (4) for supplying an output signal to said memory control circuit (4) after receiving an output signal from said logic element (7) a set number of times.

11. Waveform analyser, especially transient recorder, (15) as claimed in Claim 10, characterized by a turn-off element (12) coupled to the counter (14) and to the logic element (7) for turning off said logic element (7) for a period of time that is adjustable by the setting means (3).

12. Waveform analyser, especially transient recorder, (15) as claimed in Claim 10 or 11, characterized by a delaying element (13) coupled between the counter (14) and the memory control element (4) for delaying the output signal of said counter (14) for a period of time adjustable by the setting means (3).

13. Waveform analyser, especially transient recorder, as claimed in any of the foregoing claims, characterized by a time window circuit (15) connected to the logic element (7) which is adjustable, and adjustable with said logic element, such that after receipt of a signal from one of the comparing elements (5, 6) at least one point in time can be set in said logic element (7) using said time window circuit (15) to determine that a signal from the other of the comparing elements (5, 6) is operative.

14. Waveform analyser, especially transient recorder, as claimed in Claim 13, characterized in that two points in time can be set in the logic element using the time window circuit (15).

**Patentansprüche**

1. Signalformanalysator, insbesondere Transientenschreiber (15) für digitalisierte Aufzeichnungssignale aufgrund eines Transientenphänomens relativ kurzer Dauer, der umfaßt: wenistens ein Aufzeichnungsmodul (17) mit einem Eingang (16), der mit den Transientensignalen verbunden wird, einem Analog-Digital-Wandler (19), der mit dem Eingang (16) verbunden ist, und einem Anzeigeteil (1), das mit dem Wandler (19) verbunden ist und den Zeitpunkt anzeigt, zu dem die digitale Speicherung eines Signales in einem Speicher (2) stattzufinden hat, wobei das Anzeigeteil (1) mit Stelleinrichtungen (3) zur Einstellung von Anzeigewerten versehen ist, gekennzeichnet durch zwei oder mehrere Signalvergleicher (5, 6) für digitalisierte Signale, die Teil des Anzeigeteiles (1) sind, mit Signalen von dem Analog-Digital-Wandler (19) versorgt werden, und durch die Stelleinrichtungen (3) einstellbar sind, um die digitalisierten Signalwerte mit zwei oder mehreren der digitalen Anzeigenwerte zu vergleichen und ebenso ein Teil des Anzeigeteils (1) zu sein, und durch ein funktionell anpaßbares logisches Element (7), das mit den Ausgängen der Signalvergleicher (5, 6) verbunden ist, wobei der Ausgang des logischen Elementes mit einem Speicher-Steuerkreis (4) verbunden ist, der mit dem Speicher (2) zum Steuern der Speicherung der digitalisierten Signale in den Speicher (2) verbunden ist, in Übereinstimmung mit dem Ausgangssignal des Anzeigeteils (1).

2. Signalformanalysator, insbesondere Transientenschreiber (15), nach Anspruch 1, dadurch gekennzeichnet, daß das logische Element (7) so funktionell eingestellt werden kann, daß der Steuerkreis (4) aktiviert wird, sobald der Signalwert einen ersten Anzeigewert in einer vorbestimmten Richtung überschreitet, nachdem er zunächst einen zweiten Anzeigewert in vorbestimmter Richtung überschritten hat.

3. Signalformanalysator, insbesondere Transientenschreiber (15), nach Anspruch 1 oder 2, dadurch gekennzeichnet, daß das logische Element (7) funktionell so einstellbar ist, und die Stelleinrichtungen (3) so einstellbar sind, daß der Steuerkreis (4) aktiviert wird, sobald der Signalwert lediglich einen der beiden Anzeigenwerte nacheinander in unterschiedlichen Richtungen überschritten hat.

4. Signalformanalysator, insbesondere Transientenschreiber (15), nach wenigstens einem der Ansprüche 1, 2 oder 3, dadurch gekennzeichnet, daß das logische Element (7) funktionell so eingestellt werden kann, daß der Steuerkreis (4) aktiviert wird, sobald der Signalwert einen der beiden Anzeigenwerte in einer vorbestimmten Richtung überschreitet.

5. Signalformanalysator, insbesondere Transientenschreiber (15) nach wenigstens einem der vorstehenden Ansprüche, dadurch gekennzeichnet, daß ein Spitzenfilter (8, 9) zwischen jedem Signalvergleicher (5, 6) und dem logischen Element (7) angeschlossen ist.

6. Signalformanalysator, insbesondere Transientenschreiber (15) nach Anspruch 5, dadurch gekennzeichnet, daß der Spitzenfilter so einstellbar ist, daß bei konstant bleibenden Samples während der Zeitdauer einer vorbestimmten Anzahl von Samples dieser Spitzenfilter dem logischen Element (7) das Ausgangssignal des Signalvergleichers (5, 6) überträgt.

7. Signalformanalysater, insbesondere Transientenschreiber (15) nach Anspruch 5 oder 6, dadurch gekennzeichnet, daß der Spitzenfilter so eingestellt werden kann, daß er bei konstant bleibenden Samples während einer Zeitdauer, die kleiner ist als die Zeitdauer einer vorbestimmten Anzahl von Samples, dem logischen Element das Ausgangssignal des Signalvergleichers (5, 6) überträgt.

8. Signalformanalysator, insbesondere Transientenschreiber (15) nach wenigstens einem der vorstehenden Ansprüche, gekennzeichnet durch eine Recheneinheit (10) zur Berechnung der Differenz zwischen zwei Samples und durch einen mittels einer Stelleinrichtung (3) einstellbaren Schalter (11), der entweder den Signalwert oder die Differenz dem Signalvergleicher (5, 6) zuschaltet.

9. Signalformanalysator, inbesondere Transientenschreiber (15) nach Anspruch 8, dadurch gekennzeichnet, daß die Recheneinheit (10) so einstellbar ist, daß sie während einer vorbestimmten Zeitperiode die aufeinander folgenden Differenzen anordnet und speichert.

10. Signalformanalysator, insbesondere Transientenschreiber (15) nach wenigstens einem der vorstehenden Ansprüche, gekennzeichnet durch einem über die Stelleinrichtung (3) einstellbaren Zähler, der zwischen das logische Element (7) und en Speicher-Steuerkreis (4) gekoppelt ist, um ein Ausgangssignal dem Speicher-Steuerkreis (4) zuzuführen, nachdem er ein Ausgangssignal von dem logischen Element (7) eine vorbestimmte Zeit lang empfangen hat.

11. Signalformanalysator, insbesondere Transientenschreiber (15) nach Anspruch 10, gekennzeichnet, durch ein Ausschaltelement (12), das mit dem Zähler (14) und dem logischen Element (7) gekoppelt ist und das logische Element (7) eine durch die Stelleinrichtungen (3) einstellbare Zeitdauer lang abschaltet.

12. Signalformanalysator, insbesondere Transientenschreiber (15) nach Anspruch 10 oder 11, gekennzeichnet durch ein Verzögerungsglied (13), das zwischen den Zähler (14) und dem Speicher-Steuerelement (4) gekoppelt ist, um das Ausgangssignal des Zählers (14) eine über die Stelleinrichtungen (3) einstellbare Zeitdauer lang zu verzögern.

13. Signalformanalysator, insbesondere Transientenschreiber, nach wenigstens einem der vorstehenden Ansprüche, gekennzeichnet durch einen Zeitfensterkreis (15), der mit dem einstellbaren logischen Element (7) verbindbar ist, und mit dem logischen Element einstellbar ist, derart, daß nach Empfang eines Signales von einem der Signalvergleicher (5, 6) mindestens ein rechtzeitiger Zeitpunkt in dem logischen Element (7) eingestellt werden kann, wobei der Zeitfensterkreis (15) verwendet wird, um zu bestimmen, daß ein Signal von dem anderen der Signalvergleicher (5, 6) tätig ist.

14. Signalformanalysator, insbesondere Transientenschreiber, nach Anspruch 13, dadurch gekennzeichnet, daß zwei rechtzeitige Zeitpunkte in dem logischen Element unter Verwendung des Zeitfensterkreises (15) bestimmt werden können.

**Revendications**

1. Analyseur de forme d'onde, fonctionnant particulièrement comme enregistreur de perturbations (15) pour enreigstrer sous forme numérique des signaux causés par un phénomène transitoire d'une durée relativement courte, comprenant au moins un module d'enregistrement (17) présentant une entrée (16) qui doit être reliée aux signaux transitoires, un convertisseur analogique/numérique (19) relié à ladite entrée (16) et un organe de détection (1) relié audit convertisseur (19) pour détecter le moment où doit se produire le stockage numérique d'un signal dans une mémoire (2), lequel organe de détection (1) est pourvu de moyens de réglage (3) pour régler des seuils de détection, caractérisé par deux ou plusieurs éléments de comparaison (5, 6) pour une comparaison des signaux numérisés, qui font partie dudit organe de détection (1) et reçoivent des signaux provenant du convertisseur analogique/numérique (19) et peuvent être réglés au moyen desdits moyens de réglage (3), afin de comparer le niveau du signal numérisé avec deux ou plusieurs desdits niveaux de détection numérisés et faisant également partie dudit organe de détection (1), et par un élément logique (7) réglable lors de son fonctionnement relié aux sorties desdits éléments de comparaison (5, 6), la sortie de l'élément logique étant reliée à un circuit de commande de mémoire (4) qui est relié à ladite mémoire (2) pour commander le stockage desdits signaux numérisés dans ladite mémoire (2) en fonction du signal de sortie de l'organe de détection (1).

2. Analyseur de forme d'onde, fonctionnant particulièrement comme enregistreur de perturbations (15), selon la revendication 1, caractérisé en ce que l'élément logique (7) peut être réglé lors de son fonctionnement de sorte que le circuit de commande (4) est activé dès que le niveau du signal dépasse un premier seuil de détection dans une direction prédéterminée après avoir d'abord dépassé un deuxième seuil de détection dans une direction prédéterminée.

3. Analyseur de forme d'onde, fonctionnant particulièrement comme enregistreur de perturbations (15) selon la revendication 1 ou 2, caractérisé en ce que l'élément logique (7) peut être réglé lors de son fonctionnement et en ce que les moyens de réglage (3) peuvent être réglés de telle sorte que le circuit de commande (4) est activé dès que le niveau du signal dépasse un des deux seuils de détection successivement dans des directions différentes.

4. Analyseur de forme d'onde, fonctionnant particulièrement comme enregistreur de perturbations (15), selon l'une des revendications 1, 2, 3, caractérisé en ce que l'élément logique (7) peut être réglé lors de son fonctionnement de telle sorte que le circuit de commande (4) soit activé dès que le niveau du signal dépasse un des deux seuils de détections dans une direction prédéterminée.

5. Analyseur de forme d'onde, fonctionnant particulièrement comme enregistreur de perturbations (15), selon l'une des revendications précédentes, caractérisé en ce qu'un filtre de crête (8, 9) est connecté entre chaque élément de comparaison (5, 6) et l'élément logique (7).

6. Analyseur de forme d'onde, fonctionnant particulièrement comme enregistreur de perturbations (15), selon la revendication 5, caractérisé en ce que le filtre de crête peut être réglé de telle sorte que, lorsque les échantillons demeurent constants pendant la durée d'un nombre présélectionné d'échantillons, ledit filtre de crête transmette le signal de sortie de l'élément de comparaison (5, 6) à l'élément logique (7).

7. Analyseur de forme d'onde, fonctionnant particulièrement comme enregistreur de perturbations (15), selon la revendication 5 ou 6, caractérisé en ce que le filtre de crête peut être réglé de telle sorte que, lorsque les échantillons demeurent constants pendant une durée inférieure à la durée d'un nombre prédéterminé d'échantillons, ledit filtre de crête transmette le signal de sortie de l'élément de comparaison (5, 6) à l'élément logique.

8. Analyseur de forme d'onde, fonctionnant particulièrement comme enregistreur de perturbations (15), selon l'une des revendications précédentes, caractérisé en ce qu'il présente une unité arithmétique (10) pour calculer la différence entre deux échantillons et un organe commutateur (11) réglable par des moyens de réglage (3) pour transmettre soit le niveau du signal soit ladite différence aux éléments de comparaison (5, 6).

9. Analyseur de forme d'onde, fonctionnant particulièrement comme enregistreur de perturbations (15), selon la revendication 8, caractérisé en ce que l'unité arithmétique (10) peut être réglée de telle sorte qu'elle élabore et stocke les différences successives durant une période de temps prédéterminée.

10. Analyseur de forme d'onde, fonctionnant particulièrement comme enregistrer de perturbations (15) selon l'une des revendications précédentes, caractérisé en ce qu'il est pourvu d'un compteur (14) réglable par les moyens de réglage (3) et couplé entre l'élément logique (7) et le circuit de commande de mémoire (4) pour fournir un signal de sortie audit circuit de commande de mémoire (4) après avoir reçu un signal de sortie provenant dudit élément logique (7) un certain nombre de fois, ce nombre étant prédéterminé.

11. Analyseur de forme d'onde, fonctionnant particulièrement comme enregistreur de perturbations (15), selon la revendication 10, caractérisé en ce qu'il est pourvu d'un élément interrupteur (12) couplé au compteur (14) et à l'élément logique (7) pour désactiver ledit élément logique (7) pendant un laps de temps pouvant être fixé par les moyens de réglage (3).

12. Analyseur de forme d'onde, fonctionnant particulièrement comme enregistreur de perturbations (15), selon la revendication 10 ou 11, caractérisé en ce qu'il est pourvu d'un élément retardateur (13) couplé entre le compteur (14) et l'élément de commande de mémoire (4) pour retarder le signal de sortie dudit compteur (14) pendant un laps de temps pouvant être fixé par les moyens de réglage (3).

13. Analyseur de forme d'onde, fonctionnant particulièrement comme enregistreur de perturbations (15), selon l'une des revendications précédentes, caractérisé en ce qu'il est pourvu d'un circuit de fenêtre de temps (15) relié à l'élément logique (7) qui est réglable, avec ledit élément logique, de sorte qu'après réception d'un signal provenant de l'un des éléments de comparaison (5, 6) au moins un repère temporel peut être fixé dans ledit élément logique (7) en utilisant ledit circuit de fenêtre de temps (15) pour déterminer qu'un signal provenant de l'autre élément de comparaison (5, 6) est recevable.

14. Analyseur de forme d'onde, fonctionnant particulièrement comme enregisteur de perturbations (15), selon la revendication 13, caractérisé en ce que deux repères temporels peuvent être fixé dans l'élément logique en utilisant le circuit de fenêtre de temps (15).

FIG.2

FIG.3

FIG. 4